# FASCICULE DE BREVET EUROPEEN

(11) **EP 3 175 489 B1**
(45) Date de publication et mention de la délivrance du brevet: **01.04.2020**
(21) Numéro de dépôt: 15744169.2
(22) Date de dépôt: 27.07.2015
(51) Int. Cl.: H01L 31/048

(54) **DISPOSITIF ÉLECTRIQUE ET/OU ÉLECTRONIQUE COMPORTANT AU MOINS DEUX COMPOSANTS ÉLECTRIQUES ET/OU ÉLECTRONIQUES DISPOSANT CHACUN DE DEUX SYSTÈMES DE PROTECTION MÉCANIQUE**
ELEKTRISCHE UND/ODER ELEKTRONISCHE VORRICHTUNG MIT MINDESTENS ZWEI ELEKTRISCHEN UND/ODER ELEKTRONISCHEN KOMPONENTEN MIT JE ZWEI SYSTEMEN FÜR MECHANISCHEN SCHUTZ
ELECTRICAL AND/OR ELECTRONIC DEVICE COMPRISING AT LEAST TWO ELECTRICAL AND/OR ELECTRONIC COMPONENTS EACH EMPLOYING TWO SYSTEMS FOR MECHANICAL PROTECTION.

(30) Priorité: 28.07.2014 FR 1457272
(43) Date de publication de la demande: 07.06.2017
(73) Titulaire: Commissariat à l'Énergie Atomique et aux Énergies Alternatives, 75015 Paris (FR)
(72) Inventeur: PILAT, Eric, 73100 Brison-Saint-Innocent (FR)
(74) Mandataire: Brevalex
(86) Numéro de dépôt international: PCT/EP2015/067100
(87) Numéro de publication internationale: WO 2016/016159

(56) Documents cités:
- WO-A2-2012/088098
- DE-A1- 10 356 690
- FR-A1- 2 990 060
- US-A1- 2010 186 801

## Description

### DOMAINE TECHNIQUE

La présente invention se rapporte au domaine des dispositifs électriques et/ou électroniques comportant des composants électriques et/ou électroniques, par exemple encapsulés. L'invention s'applique particulièrement à des dispositifs comportant au moins une face transparente permettant aux composants électriques et/ou électroniques d'émettre et/ou de recevoir un flux lumineux.

L'invention est particulièrement concernée par le domaine des modules photovoltaïques qui comportent un ensemble de cellules photovoltaïques reliées entre elles électriquement, et notamment des cellules photovoltaïques dites « cristallines », c'est-à-dire qui sont à base de cristaux de silicium ou de polycristaux de silicium.

Elle concerne également, de façon plus générale, le domaine des dispositifs électriques et/ou électroniques qui comportent des composants mécaniquement fragiles, et en particulier des composants optoélectroniques, par exemple encapsulés, tels que des capteurs de type CCD (à couplage de charge), CMOS, ou encore le domaine des écrans plats, par exemple de type LCD (écran à cristaux liquides), plasma ou LED (écran à diodes luminescentes).

L'invention propose ainsi un dispositif électrique et/ou électronique comportant un système de protection mécanique d'au moins un composant électrique et/ou électronique, ainsi qu'un procédé de réalisation d'un tel dispositif électrique et/ou électronique.

### ÉTAT DE LA TECHNIQUE ANTÉRIEURE

Un module photovoltaïque est un assemblage de cellules photovoltaïques disposées côte à côte entre une première couche transparente, par exemple à base de verre, formant une face avant du module photovoltaïque et une seconde couche, pouvant elle aussi être transparente, et par exemple à base de verre, de métal ou de plastique, formant une face arrière du module photovoltaïque.

Les cellules photovoltaïques sont reliées électriquement en série entre elles par des éléments de contact électrique avant et arrière, appelés conducteurs de liaison, et formés par exemple par des bandes de cuivre, respectivement disposées contre les faces avant (faces se trouvant en regard de la face avant du module photovoltaïque destinée à recevoir les flux lumineux) et arrière (faces se trouvant en regard de la face arrière du module photovoltaïque) de chacune des cellules photovoltaïques.

Par ailleurs, afin que le module photovoltaïque forme un ensemble rigide, celui-ci peut comporter un cadre entourant un ensemble de couches laminées formant un ensemble encapsulant dans lequelle les cellules photovoltaïques sont disposées. En variante, le module photovoltaïque pourrait également être dépourvu d'un tel cadre, ce qui peut par exemple être le cas pour des modules photovoltaïques disposés verticalement, des modules avec du double vitrage ou encore des modules avec des épaisseurs supérieures à 5 mm.

Lors de la fabrication du module photovoltaïque, on utilise généralement deux couches (ou films) d'éthylène-acétate de vinyle (EVA) entre lesquelles sont disposées les cellules photovoltaïques et les conducteurs de liaison des cellules, ainsi qu'une couche de verre superposée sur la couche d'EVA se trouvant en regard des faces avant des cellules photovoltaïques, et une couche à base de verre ou d'un matériau composite tel qu'un laminé à base de polyfluorure de vinyle (PVF) ou de polyéthylène téréphtalate (PET), disposée contre l'autre couche d'EVA se trouvant en regard des faces arrière des cellules photovoltaïques. Toutefois, après l'opération de laminage des couches, les deux couches d'EVA ont fondu pour ne former qu'une seule couche dans laquelle sont noyées les cellules photovoltaïques.

Ce principe connu d'encapsulation des cellules photovoltaïques pour former un module photovoltaïque rigide n'est pas entièrement satisfaisant et présente plusieurs inconvénients.

Tout d'abord, une telle conception est coûteuse, les techniques mises en œuvre pour réaliser cette encapsulation représentant environ 30 % du coût total du module photovoltaïque.

Aussi, afin de réduire le coût de fabrication des modules photovoltaïques, et notamment pour économiser l'utilisation du silicium dans les cellules photovoltaïques cristallines, une première tendance vise à concevoir des cellules photovoltaïques de plus en plus fines au détriment de leur robustesse mécanique. En effet, la conception précédente ne permet pas de garantir une bonne protection mécanique des cellules photovoltaïques.

De plus, une deuxième tendance vise à utiliser de telles cellules photovoltaïques, et notamment des cellules photovoltaïques cristallines, dans des applications de plus en plus contraignantes qui les sollicitent considérablement au niveau de leur résistance mécanique.

Or, les cellules photovoltaïques, et notamment les cellules photovoltaïques cristallines, sont souples mais très fragiles et susceptibles de se casser aisément.

En particulier, ces cellules photovoltaïques peuvent se fissurer lorsqu'elles sont soumises à des contraintes sévères, par exemple des vibrations liées au transport. Les fissures formées sur les cellules photovoltaïques ne sont parfois même pas visibles et ne provoquent pas d'effets électriques immédiats évidents, ce qui complique leur détection. Dans certains cas de figure, comme par exemple pour la technologie d'encapsulation dite « N.I.C.E. » (pour « New Industrial solar Cell Encapsulation technology » en anglais, développée par Appolon Solar et telle que décrite dans la demande de brevet WO 03/038911 A1), de telles contraintes, appliquées aux cellules photovoltaïques, peuvent également résulter de variations de température, par exemple comprises entre environ -40°C et +90°C, qui engendrent des variations de pression dans le volume intérieur où les cellules sont encapsulées. Les contraintes localisées sont d'autant plus importantes que les irrégularités des surfaces (celles des substrats en verre en particulier) à l'intérieur du volume sont importantes.

Or, de telles fissures dans une cellule photovoltaïque peuvent, dès leur formation ou plus tard au cours de la vie de la cellule, séparer et isoler une partie de la cellule vis-à-vis des contacts électriques de la cellule, pouvant entraîner une perte d'une partie de l'électricité produite par la cellule. Parmi les configurations de casse des cellules photovoltaïques les plus critiques, on peut notamment citer les configurations de cassures du type « dendritiques », « variées » ou encore « parallèles extérieures ».

C'est pourquoi, il existe un besoin pour parvenir à protéger efficacement les cellules photovoltaïques de tous les risques de détérioration qu'elles peuvent subir, et notamment ceux liés aux chocs et fortes charges mécaniques survenant au cours de leur vie et/ou pendant leur manutention ou transport, auquel les modules photovoltaïques conçus selon le principe de l'art antérieur décrit ci-dessus ne parviennent pas à répondre de façon significative.

Par ailleurs, les inconvénients mentionnés ci-dessus pour les modules photovoltaïques peuvent également se retrouver dans d'autres types de dispositifs électriques et/ou électroniques comportant des composants mécaniquement fragiles, et notamment dans des dispositifs optoélectroniques tels que des dispositifs imageurs (CCD, CMOS, ...) ou des dispositifs de type afficheur électronique (LCD, plasma, LED, ...) comportant des composants encapsulés, et dans lesquels on cherche à obtenir un bon contact électrique avec le ou les composants du dispositif malgré les irrégularités de surface des couches entre lesquelles le ou les composants sont encapsulés.

Le document WO 2012/088098 A2 décrit l'encapsulation de cellules solaires dans un module photovoltaïque, chaque cellule solaire étant encapsulée et protégée dans une couche supérieure transparente et une couche inférieure. Une couche d'enrobage supérieure est prévue entre la couche supérieure et la cellule solaire, et une couche d'enrobage inférieure est prévue entre la couche inférieure et la cellule solaire. La couche d'enrobage supérieure est constituée de matériaux thermofixés ou non thermofixés tels que l'EVA, le PVB, le silicone, les résines polyépoxydes. La couche d'enrobage inférieure est constituée de matériaux thermofixés ou non thermofixés tels que l'EVA, le PVB, les résines de silicone polyépoxydes.

### EXPOSÉ DE L'INVENTION

L'invention a ainsi pour but de remédier au moins partiellement aux besoins mentionnés ci-dessus et aux inconvénients relatifs aux réalisations de l'art antérieur.

Elle vise notamment à proposer une solution alternative pour conférer plus de robustesse à un dispositif électrique et/ou électronique comportant des composants électriques et/ou électroniques, et notamment à un module photovoltaïque comportant des cellules photovoltaïques, en particulier des cellules photovoltaïques cristallines.

L'invention a ainsi pour objet, selon l'un de ses aspects, un dispositif électrique et/ou électronique selon la revendication 1.

Grâce à l'invention, il peut ainsi être possible d'apporter une solution alternative de protection mécanique des composants électriques et/ou électroniques d'un dispositif électrique et/ou électronique, et notamment des cellules photovoltaïques d'un module photovoltaïque. En outre, l'invention peut permettre de conférer de la robustesse à un dispositif électrique et/ou électronique, notamment aux composants électriques et/ou électroniques qu'il comporte, tout en restant satisfaisante en termes de poids et de flexibilité du dispositif électrique et/ou électronique. Le système de protection mécanique du dispositif électrique et/ou électronique selon l'invention peut avoir un rôle de bouclier qui empêche tout contact entre l'environnement extérieur et le ou les composants électriques et/ou électroniques qu'il protège.

Le dispositif électrique et/ou électronique selon l'invention peut en outre comporter l'une ou plusieurs des caractéristiques suivantes prises isolément ou suivant toutes combinaisons techniques possibles.

Ledit au moins un élément d'absorption de déformation peut être inclus dans un système d'absorption de déformation.

Le système de protection mécanique et le système d'absorption de déformation peuvent permettre de protéger le ou les composants électriques et/ou électroniques qu'ils protègent des chocs et charges mécaniques pouvant être subis au cours de la vie du dispositif selon l'invention et/ou au cours d'opérations de manutention ou de transport.

Le système de protection mécanique peut ainsi s'apparenter à un bouclier superposé à un ou des composants électriques et/ou électroniques pour leur protection.

Le ou les éléments de protection peuvent notamment avoir la forme d'une coque superposée à un ou des composants électriques et/ou électroniques.

Avantageusement, la présence d'un élément d'absorption de déformation peut permettre d'éviter un contact entre la face externe du dispositif (avant ou arrière) et un composant électrique et/ou électronique associé à l'élément d'absorption de déformation. De cette façon, on peut éviter les risques de détérioration, et notamment de fissuration, des composants électriques et/ou électroniques du dispositif.

Le dispositif selon l'invention peut comporter une pluralité d'éléments de contact électrique tels que chacune des deux faces opposées de chacun desdits au moins deux composants électriques et/ou électroniques comporte au moins un des éléments de contact électrique disposé contre ladite chacune des deux faces opposées dudit chacun desdits au moins deux composants électriques et/ou électroniques.

La couche de matériau formant la face avant du dispositif selon l'invention, pouvant notamment comporter un ou plusieurs éléments de protection, peut être transparente, les composants électriques et/ou électroniques pouvant être aptes à émettre et/ou recevoir au moins un flux lumineux à travers la face avant du dispositif, par exemple à travers un ou plusieurs éléments de protection. Le ou les éléments de protection peuvent ainsi être transparents.

Le terme « transparent » signifie que le matériau de la couche formant la face avant du dispositif, notamment le matériau d'un élément de protection, est au moins partiellement transparent à la lumière visible, laissant passer au moins environ 80 % de cette lumière.

Chaque composant électrique et/ou électronique est protégé mécaniquement par deux éléments de protection qui lui sont spécifiques.

Chaque composant électrique et/ou électronique est pris entre deux éléments de protection, un premier élément de protection étant disposé en superposition par rapport au(x) composant(s) électrique(s) et/ou électronique(s) qu'il protège, en regard de l'une de ses deux faces opposées, et un deuxième élément de protection étant disposé en superposition par rapport au(x) composant(s) électrique(s) et/ou électronique(s) qu'il protège, en regard de l'autre de ses deux faces opposées.

Le premier élément de protection et le deuxième élément de protection sont assemblés entre eux, notamment par collage.

Le premier élément de protection et le deuxième élément de protection peuvent respectivement former, au moins en partie, des faces avant et arrière du dispositif électrique et/ou électronique, entre lesquels ne sont disposés que le composant électrique et/ou électronique, que les premier et deuxième éléments de protection protègent, ledit au moins un élément de contact électrique qui lui est associé et au moins un premier élément d'absorption de déformation et un deuxième élément d'absorption disposés de part et d'autre dudit composant électrique et/ou électronique.

Le dispositif peut en outre comporter une pluralité d'éléments de protection et au moins une partie des éléments de protection du dispositif électrique et/ou électronique, notamment la totalité, peut former une disposition sensiblement régulière de formes polygonales, notamment rectangulaires ou carrés.

En particulier, au moins certains des éléments de protection peuvent être disposés sous la forme d'un damier, comportant une répartition régulière de cases adjacentes, voire dit autrement, être disposés sous la forme d'une tablette de chocolat. La disposition d'au moins certains des éléments de protection peut donc présenter un aspect de dallage. Un tel aspect peut par exemple permettre de répondre à des attendus esthétiques.

Le ou les éléments de protection peuvent également comporter au moins un canal ajouré permettant le passage dudit au moins un élément de contact électrique.

Grâce à la présence d'un tel canal ajouré dans un élément de protection, l'élément de contact électrique peut être protégé par l'élément de protection. En particulier, il peut éviter de subir une pression mécanique qui risquerait de le détériorer.

Le ou les éléments de protection peuvent être réalisés dans un matériau ayant une dureté supérieure à 60 sur l'échelle M rockwell, selon la norme « Standard Test Method for Rockwell Hardness of Plastics and Electrical Insulating Materials » ASTM D785.

Le ou les éléments de protection peuvent être réalisés dans un matériau choisi parmi : du polyméthacrylate de méthyle (PMMA), du polycarbonate ou du verre, entre autres. Le ou les éléments d'absorption de déformation comporte un gaz sous haute pression avec une pression comprise entre 5 et 15 bars. Lesdits au moins deux composants électriques et/ou électroniques sont des cellules photovoltaïques, et notamment des cellules photovoltaïques cristallines, voire encore des cellules photovoltaïques à base de silicium amorphe ou à couches minces telles que les cellules à base de CIGS ou de CdTe, et ledit au moins un élément de contact électrique peut comporter au moins une bande de matériau électriquement conducteur disposée contre les cellules photovoltaïques et reliant les cellules photovoltaïques électriquement entre elles.

Le ou les éléments de contact électrique peuvent par exemple être constitués par une bande de cuivre.

Le dispositif selon l'invention peut par ailleurs comporter une pluralité d'éléments de protection, et peut être plus rigide au niveau des éléments de protection qu'au niveau des parties de connexion entre les éléments de protection, la souplesse de ces parties de connexion définissant la flexibilité du dispositif électrique et/ou électronique.

En outre, le dispositif selon l'invention peut comporter une pluralité d'éléments de protection, et la distance entre deux éléments de protection successifs peut être supérieure ou égale à 10 mm.

Par ailleurs, le ou les éléments de protection peuvent par exemple présenter une largeur et/ou une longueur supérieure ou égale à 100 mm. En particulier, le ou les éléments de protection peuvent se présenter sensiblement sous la forme d'un carré de côté supérieur ou égal à 100 mm.

Dans un mode de réalisation de l'invention, ledit au moins un élément de protection peut être au moins partiellement enfoncé dans au moins l'une desdites au moins deux couches de matériau d'encapsulation du dispositif électrique et/ou électronique, notamment réalisée en résine d'éthylène-acétate de vinyle (EVA).

Par ailleurs, le ou les éléments de contact électrique peuvent être au moins partiellement flexibles, notamment dans leur partie située entre lesdits au moins deux composants électriques et/ou électroniques.

Par ailleurs, l'invention a encore pour objet, selon un autre de ses aspects, un procédé de réalisation d'un dispositif électrique et/ou électronique selon la revendication 8.

Le procédé selon l'invention peut comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en perspective, un premier exemple de réalisation d'un dispositif électrique et/ou électronique non conforme à l'invention,
- la figure 2 représente un détail de réalisation du dispositif électrique et/ou électronique de la figure 1,
- les figures 3A et 3B illustrent, en coupe, deux étapes d'une première variante d'un procédé de réalisation d'un dispositif électrique et/ou électronique non conforme à l'invention,
- les figures 4A et 4B illustrent, en coupe, deux étapes d'une deuxième variante d'un procédé de réalisation d'un dispositif électrique et/ou électronique non conforme à l'invention,
- les figures 5A et 5B illustrent, en coupe, deux étapes d'une troisième variante d'un procédé de réalisation d'un dispositif électrique et/ou électronique non conforme à l'invention,
- les figures 6A, 6B et 6C illustrent, respectivement en coupe, en vue du dessus et en coupe, trois étapes d'une quatrième variante d'un procédé de réalisation d'un dispositif électrique et/ou électronique non conforme à l'invention,
- la figure 7A représente, en perspective, un autre exemple de réalisation d'un dispositif électrique et/ou électronique conforme à l'invention,
- la figure 7B est une vue en coupe du dispositif électrique et/ou électronique de la figure 7A, et
- la figure 8 illustre, en coupe, une variante de réalisation d'un élément de contact électrique d'un dispositif électrique et/ou électronique conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

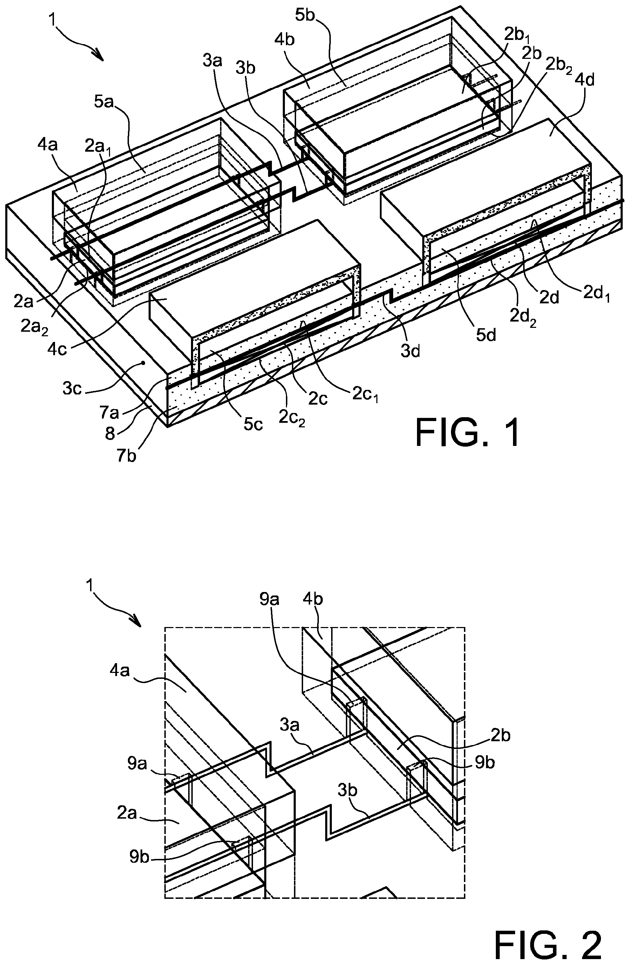

Dans tous les exemples décrits ci-après en référence aux figures 1 à 8, on considère que les dispositifs électriques et/ou électroniques 1 selon l'invention correspondent à des modules photovoltaïques 1, comportant au moins quatre composants électriques et/ou électroniques sous la forme de cellules photovoltaïques 2a, 2b, 2c et 2d, notamment des cellules photovoltaïques cristallines. Bien entendu, ce choix n'est nullement limitatif.

On se réfère tout d'abord à la figure 1 qui représente, en perspective, un premier exemple de réalisation d'un module photovoltaïque 1 non conforme à l'invention.

Le module photovoltaïque 1 comporte quatre cellules photovoltaïques 2a, 2b, 2c et 2d, reliées électriquement entre elles par des éléments de contact électrique 3a, 3b, 3c et 3d, par exemple sous la forme de bandes de cuivre. En particulier, deux éléments de contact électrique 3a et 3b relient les cellules photovoltaïques 2a et 2b entre elles, et deux autres éléments de contact électrique 3c et 3d relient les cellules photovoltaïques 2c et 2d électriquement entre elles.

De plus, les quatre cellules photovoltaïques 2a, 2b, 2c et 2d comportent respectivement des faces opposées 2a₁ et 2a₂, 2b₁ et 2b₂, 2c₁ et 2c₂, et 2d₁ et 2d₂.

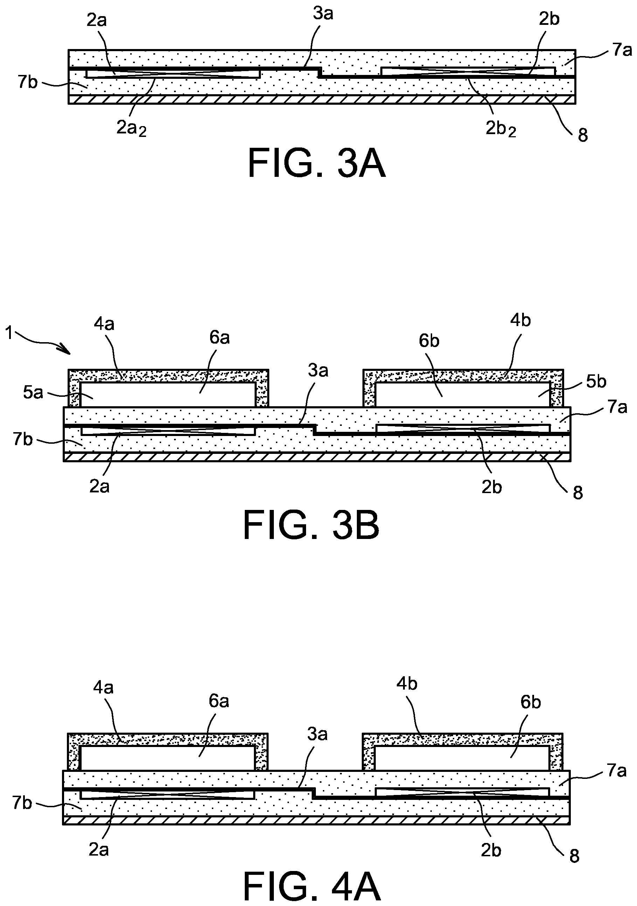

Chacun des éléments de contact électrique 3a, 3b, 3c et 3d peut être disposé contre une des deux faces opposées de chacune des cellules photovoltaïques 2a, 2b, 2c et 2d, et notamment de façon alternative. Ainsi, à titre d'exemple, comme on peut le voir plus facilement sur la figure 3A, l'élément de contact électrique 3a peut par exemple être disposé contre la face avant 2a₁ de la cellule photovoltaïque 2a et contre la face arrière 2b₂ de la cellule photovoltaïque 2b.

Par ailleurs, conformément à l'invention, chacune des cellules photovoltaïques 2a, 2b, 2c et 2d est protégée mécaniquement par un élément de protection 4a, 4b, 4c et 4d.

En particulier, dans l'exemple de la figure 1, les quatre cellules photovoltaïques 2a, 2b, 2c et 2d sont respectivement protégées mécaniquement par les quatre éléments de protection 4a, 4b, 4c et 4d.

Chacun des quatre éléments de protection 4a, 4b, 4c et 4d peut plus particulièrement être assimilé à une coque ou coquille de protection.

Dans l'exemple de la figure 1, chaque cellule photovoltaïque 2a, 2b, 2c et 2d est recouverte d'une seule coque de protection 4a, 4b, 4c et 4d qui lui est spécifique. En variante, bien que non représenté, il pourrait être possible d'avoir un élément de protection commun à au moins deux cellules photovoltaïques, c'est-à-dire recouvrant au moins deux cellules photovoltaïques pour les protéger mécaniquement.

Le recouvrement d'une ou plusieurs cellules photovoltaïques par un élément de protection peut en particulier dépendre du degré de flexibilité souhaité pour le module photovoltaïque.

Avantageusement, les coques de protection 4a, 4b, 4c et 4d peuvent être identiques, notamment en termes de dimensions.

En outre, le module photovoltaïque 1 comporte quatre éléments d'absorption de déformation 5a, 5b, 5c et 5d qui sont disposés respectivement dans quatre espaces 6a, 6b, 6c et 6d formés entre les coques de protection 4a, 4b, 4c et 4d et les cellules photovoltaïques 2a, 2b, 2c et 2d.

Plus particulièrement, comme il ressort plus clairement des vues en coupe des figures 3A à 5B, les espaces 6a, 6b, 6c et 6d comportant les éléments d'absorption de déformation 5a, 5b, 5c et 5d sont situés respectivement entre les coques de protection 4a, 4b, 4c et 4d et les cellules photovoltaïques 2a, 2b, 2c et 2d.

Avantageusement, la présence des éléments d'absorption de déformation 5a, 5b, 5c et 5d peut permettre d'éviter tout contact entre les cellules photovoltaïques 2a, 2b, 2c et 2d, et la face avant du module photovoltaïque 1, dans le cas présent formée par les quatre coques de protection 4a, 4b, 4c et 4d.

De cette façon, l'association des coques de protection 4a, 4b, 4c et 4d et des éléments d'absorption 5a, 5b, 5c et 5d permet de conférer une résistance mécanique au module photovoltaïque 1, afin de limiter, ou mieux d'éviter, tout risque de détérioration des cellules photovoltaïques 2a, 2b, 2c et 2d, et notamment afin d'éviter tout risque de fissuration. Autrement dit, les cellules photovoltaïques 2a, 2b, 2c et 2d peuvent être recouvertes d'une enveloppe rigide formée par les coques de protection 4a, 4b, 4c et 4d qui permet de se prémunir de tout contact mécanique avec l'environnement extérieur.

Il est ainsi possible de protéger les cellules photovoltaïques 2a, 2b, 2c et 2d tout en préservant également un maximum de flexibilité au module photovoltaïque 1, grâce à l'utilisation d'une coque de protection spécifique par cellule photovoltaïque et à la formation de parties souples du module photovoltaïque 1 entre les coques de protection 4a, 4b, 4c et 4d.

Dans toute la description, et en particulier pour les coques de protection 4a, 4b, 4c et 4d décrites ici, chaque coque de protection peut par exemple se présenter sous la forme d'une plaque principale avec une pluralité de nervures périphériques, sensiblement perpendiculaires à la plaque principale, de sorte à définir en section une forme de U inversé. En particulier, chaque coque de protection peut être géométriquement composé d'un plaque principale, sensiblement plane, horizontale et de forme rectangulaire, carrée ou circulaire, et de parties formant des nervures, sensiblement verticales et de forme rectangulaire, carrée ou circulaire, s'étendant depuis chaque côté de la plaque principale. Dans le cas où la plaque principale est de forme circulaire, il peut exister une seule partie formant une nervure sensiblement verticale s'étendant depuis la périphérie de la plaque principale. Les parties formant les nervures peuvent éventuellement être ajourées afin de ne pas prendre appui au niveau d'éléments électriques. Chaque coque de protection peut être réalisée par assemblage de différentes parties, à savoir la plaque principale et la ou les parties formant les nervures, en un seul bloc, par exemple moulé ou thermoformé, entre autres.

La flexibilité du module photovoltaïque 1 peut lui permettre de prendre différentes formes pour s'adapter à différents types de surfaces sur lesquelles le module photovoltaïque 1 viendrait à être disposé, par exemple des surfaces en escalier, accidentées, ou encore de planéité imparfaite.

L'épaisseur des coques de protection 4a, 4b, 4c et 4d peut être variable, et notamment plus réduite lorsque l'on souhaite conférer davantage de flexibilité au module photovoltaïque 1 selon l'invention. En tout état de cause, l'épaisseur des coques de protection 4a, 4b, 4c et 4d peut dépendre des contraintes mécaniques appliquées au module photovoltaïque 1.

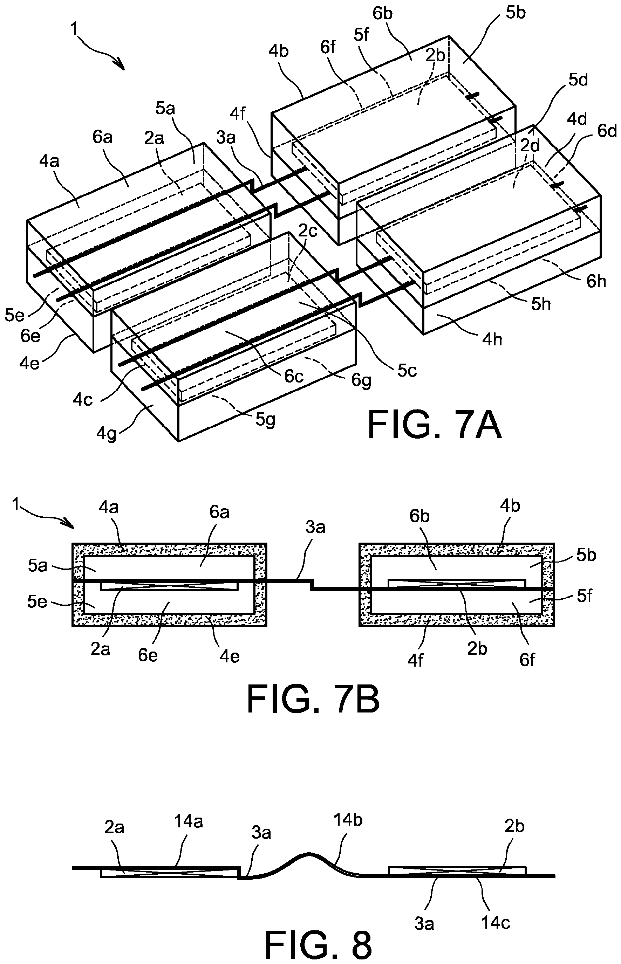

Par ailleurs, dans l'exemple de la figure 1 mais également dans les exemples de réalisation des figures 3A à 6C, à l'inverse de l'exemple de réalisation des figures 7A et 7B, le module photovoltaïque 1 comporte en outre deux couches de matériau d'encapsulation 7a et 7b, entre lesquelles les quatre cellules photovoltaïques 2a, 2b, 2c et 2d sont encapsulées, les coques de protection 4a, 4b, 4c et 4d et les éléments d'absorption de déformation 5a, 5b, 5c et 5d étant disposés relativement à l'une 7a des deux couches de matériau d'encapsulation 7a et 7b de sorte que celle-ci s'étende entre l'ensemble formé par les coques de protection 4a, 4b, 4c et 4d et les éléments d'absorption de déformation 5a, 5b, 5c et 5d, et les cellules photovoltaïques 2a, 2b, 2c et 2d qu'ils protègent.

L'autre 7b des deux couches de matériau d'encapsulation 7a et 7b est par ailleurs recouverte d'une couche de fond 8, notamment du type polymérique, qui définit la face arrière du module photovoltaïque 1, tandis que les coques de protection 4a, 4b, 4c et 4d, préférentiellement transparentes, définissent la face avant du module photovoltaïque 1.

Il est également à noter qu'avantageusement, les quatre coques de protection 4a, 4b, 4c et 4d forment entre elles un motif régulier, notamment sous la forme d'une tablette de chocolat.

Cette forme régulière dans la disposition des coques de protection 4a, 4b, 4c et 4d peut permettre d'améliorer la modularité et la flexibilité du module photovoltaïque 1, et également permettre de répondre à des attendus esthétiques.

Grâce à la présence des coques de protection 4a, 4b, 4c et 4d associées à l'utilisation d'éléments d'absorption de déformation 5a, 5b, 5c et 5d, il est ainsi possible d'éviter une sollicitation des cellules photovoltaïques 2a, 2b, 2c et 2d par des contraintes mécaniques extérieures. L'invention permet donc de conférer la robustesse nécessaire au module photovoltaïque 1 pour protéger les cellules photovoltaïques 2a, 2b, 2c et 2d.

Il est en outre à noter que chacune des coques de protection 4a, 4b, 4c et 4d peut être réalisée dans un matériau flexible, de sorte que le module photovoltaïque peut le cas échéant être plié ou roulé en fonction des besoins des applications visées.

Chacune des coques de protection 4a, 4b, 4c et 4d peut par exemple être réalisée dans un matériau choisi parmi : du polyméthacrylate de méthyle (PMMA), du polycarbonate ou du verre.

En outre, chacun des éléments d'absorption de déformation 5a, 5b, 5c et 5d comporte avantageusement un matériau déformable. En particulier, dans l'exemple de la figure 1 et des figures 3B, 4A-4B, 6C et 7B, les éléments d'absorption de déformation comportent un gaz sous haute pression, notamment avec une pression comprise entre 5 et 15 bars.

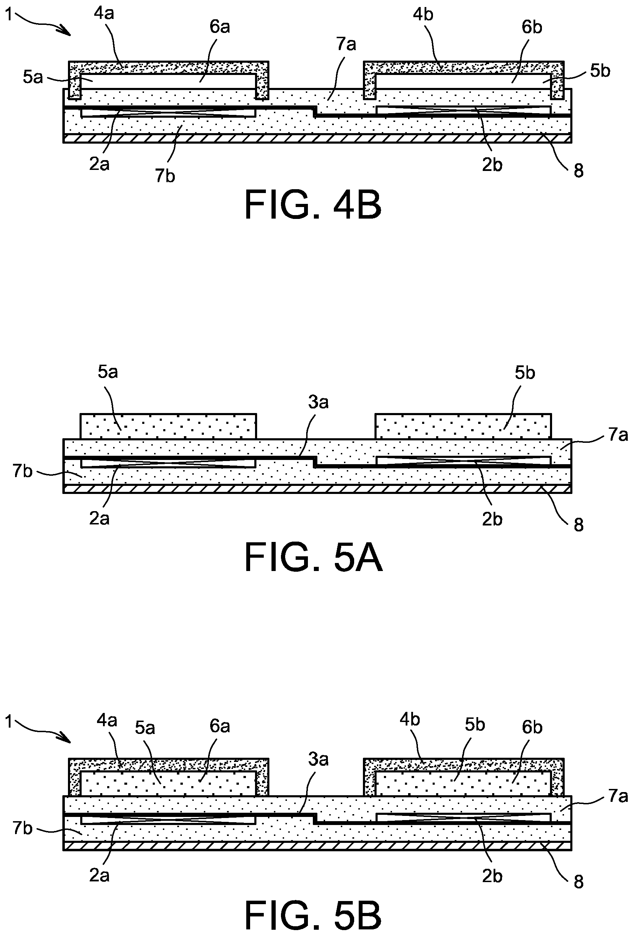

En variante, les éléments d'absorption de déformation peuvent être choisis parmi d'autres types de matériaux, et notamment comporter du polystyrène transparent, comme il sera décrit en référence aux figures 5A et 5B par la suite.

On a par ailleurs représenté sur la figure 2 un détail de réalisation du module photovoltaïque 1 de la figure 1, et en particulier la zone située entre les deux cellules photovoltaïques 2a et 2b.

Comme on peut le voir sur cette figure 2, chacune des coques de protection 4a, 4b, 4c et 4d peut comporter au moins un canal ajouré 9a ou 9b pour permettre le passage d'un élément de contact électrique 3a, 3b, 3c ou 3d.

Plus précisément, sur la figure 2, la coque de protection 4a comporte un canal ajouré 9a pour permettre le passage de l'élément de contact électrique 3a et un canal ajouré 9b pour permettre le passage de l'élément de contact électrique 3b. De même, la coque de protection 4b comporte un canal ajouré 9a pour permettre le passage de l'élément de contact électrique 3a et un canal ajouré 9b pour permettre le passage de l'élément de contact électrique 3b.

De cette façon, grâce à la présence de canaux ajourés 9a et 9b formés dans les coques de protection 4a et 4b, il peut être possible de protéger les éléments de contact électrique 3a et 3b de toute pression mécanique qui pourrait être exercée sur les coques de protection 4a et 4b.

On va maintenant décrire ci-après, en référence aux figures 3A à 6C, quatre variantes d'un procédé de réalisation d'un module photovoltaïque 1 non conforme à l'invention.

Dans chacune de ces variantes, le procédé comporte au moins les étapes consistant à :
- a) réaliser quatre cellules photovoltaïques 2a, 2b, 2c et 2d comportant chacune deux faces opposées 2a₁ et 2a₂, 2b₁ et 2b₂, 2c₁ et 2c₂, et 2d₁ et 2d₂,
- b) réaliser quatre éléments de contact électrique 3a, 3b, 3c et 3d pour relier les quatre cellules photovoltaïques 2a, 2b, 2c et 2d électriquement entre elles,
- c) réaliser quatre éléments ou coques de protection 4a, 4b, 4c et 4d pour protéger mécaniquement chacune des quatre cellules photovoltaïques 2a, 2b, 2c et 2d,
- d) réaliser quatre éléments d'absorption de déformation 5a, 5b, 5c et 5d qui sont disposés respectivement dans quatre espaces 6a, 6b, 6c et 6d formés entre les quatre coques de protection 4a, 4b, 4c et 4d et les quatre cellules photovoltaïques 2a, 2b, 2c et 2d.

Les figures 3A et 3B illustrent tout d'abord, en coupe, deux étapes d'un procédé de réalisation d'un module photovoltaïque 1 non conforme à l'invention, par laminage puis collage.

Ainsi, on réalise tout d'abord des cellules photovoltaïques 2a, 2b, 2c et 2d ayant par exemple la forme d'un carré de côté égale à 100 mm, ces cellules photovoltaïques 2a, 2b, 2c et 2d étant par exemple des mini-cellules découpées dans des cellules de dimensions plus grandes, et par exemple des cellules ayant une forme carrée avec un côté égal à 156 mm.

Ces quatre cellules photovoltaïques 2a, 2b, 2c et 2d sont ensuite assemblées entre elles par soudure, conformément au procédé d'assemblage selon l'art antérieur, par l'intermédiaire des éléments de contact électrique 3a, 3b, 3c et 3d, par exemple sous la forme de rubans de cuivre étamés.

Puis, comme il est illustré sur la figure 3A, une fois les cellules photovoltaïques 2a, 2b, 2c et 2d raccordées électriquement les unes aux autres, elles sont laminées de part et d'autre avec des couches de matériau d'encapsulation 7a et 7b, et une couche de fond 8 constituant la face arrière du module photovoltaïque 1.

Les couches de matériaux d'encapsulation 7a et 7b peuvent par exemple être constituées par de la résine EVA. Toutefois, en variante, l'utilisation de la résine EVA pourrait être remplacée par d'autres types de résines transparentes, et par exemple choisies dans la famille des polyuréthanes polyoléfines, par exemple polyoléfine modifié ou ionomère, ou encore du polyvinyle butylène. A titre d'exemples, on peut par exemple utiliser des produits commerciaux tels que l'Apolhya® de la société Arkema, le CVF® de la société DNP Solar ou le Jurasol DG3® de la société Juraplast.

La couche de fond 8 est par exemple constituée par une multicouche en polymère, par exemple à base de polyfluorure de vinyle (PVF) ou de polyéthylène téréphtalate (PET). A titre d'exemple, on peut citer le Tedlar® de la société Dupont.

La nature de la couche de fond 8, ainsi que son épaisseur, peuvent varier en fonction du type de protection recherchée vis-à-vis de la face arrière du module photovoltaïque 1, et également en fonction de la flexibilité attendue pour le module photovoltaïque 1.

En variante, la couche de fond 8 peut également comporter une couche métallique par exemple en acier, éventuellement protégée par un revêtement supplémentaire, notamment un revêtement isolant, par exemple du type polyuréthane, par exemple du type Pu Damival® de la société Vonrol.

Par ailleurs, les coques de protection 4a, 4b, 4c et 4d sont fabriquées en PMMA, en particulier dans le matériau dit « PMMA-choc » commercialisé par la société Arkema sous la référence Altugas® ShieldUp. En variante, les coques de protection 4a, 4b, 4c et 4d peuvent également être fabriquées en polycarbonate, comme par exemple à partir du macrolon® de la société Bayer, ou encore plus préférentiellement pour la résistance au choc, à partir du Lexan® commercialisé par la société Sabic.

Puis, comme illustré sur la figure 3B, les coques de protection 4a, 4b, 4c et 4d sont collées sur la couche de matériau d'encapsulation 7a, par exemple à l'aide d'une colle acrylique. Les coques de protection 4a, 4b, 4c et 4d sont par exemple espacées les unes des autres d'au moins 10 mm.

Par ailleurs, avant assemblage des coques de protection 4a, 4b, 4c et 4d sur la couche de matériau d'encapsulation 7a, un gaz sous haute pression est introduit entre chaque coque de protection 4a, 4b, 4c et 4d et la couche de matériau d'encapsulation 7a pour former chacun des quatre éléments d'absorption de déformation 5a, 5b, 5c et 5d. L'utilisation d'un gaz sous haute pression peut également permettre de diminuer l'épaisseur des coques de protection 4a, 4b, 4c et 4d. En variante, bien que cela soit moins satisfaisant, chaque élément d'absorption de déformation 5a, 5b, 5c et 5d pourrait être formé par l'air ambiant.

Avantageusement, les quatre éléments d'absorption de déformation 5a, 5b, 5c et 5d permettent de compenser les éventuelles déformations liées à une pression mécanique sur les coques de protection 4a, 4b, 4c et 4d, et surtout d'empêcher le contact entre les coques de protection 4a, 4b, 4c et 4d et les cellules photovoltaïques 2a, 2b, 2c et 2d.

On a également illustré sur les figures 4A et 4B, en coupe, des étapes d'une autre variante de procédé de réalisation d'un module photovoltaïque 1 non conforme à l'invention.

Dans cette variante, le module photovoltaïque 1 est réalisé par une lamination complète de ses couches constitutives.

En particulier, comme illustré sur la figure 4A, les couches de matériau d'encapsulation 7a et 7b peuvent être positionnées de part et d'autre des cellules photovoltaïques 2a, 2b, 2c et 2d. De plus, la couche de fond 8 peut également être positionnée au contact de la couche de matériau d'encapsulation 7b. Les coques de protection 4a, 4b, 4c et 4d sont également positionnées au contact de la couche de matériau d'encapsulation 7a. Ce positionnement des couches les autres relativement aux autres est effectué avant laminage.

Puis, comme illustré sur la figure 4B, on enclenche une phase de lamination des couches, au cours de laquelle la résine de la couche de matériau d'encapsulation 7a va fondre de sorte que chacune des coques de protection 4a, 4b, 4c et 4d va s'enfoncer et venir se fixer dans cette couche de matériau d'encapsulation 7a.

Par ailleurs, comme décrit précédemment, il peut être prévu d'injecter un gaz sous haute pression pour former les éléments d'absorption de déformation 5a, 5b, 5c et 5d.

Les figures 5A et 5B illustrent, en coupe, une autre variante de réalisation d'un procédé qui n'est pas selon l'invention. Dans cette variante, on utilise le surmoulage.

En particulier, comme illustré sur la figure 5A, après laminage des couches de matériau d'encapsulation 7a et 7b de part et d'autre des cellules photovoltaïques 2a, 2b, 2c et 2d et laminage d'une couche de fond 8, on vient surmouler au-dessus des cellules photovoltaïques 2a, 2b, 2c et 2d, sur la couche de matériau d'encapsulation 7a, une empreinte (ou guide) dans un matériau très compressible, comme par exemple du polystyrène expansé transparent, pour former les éléments d'absorption de déformation 5a, 5b, 5c et 5d. Puis, comme illustré sur la figure 5B, dans un second temps, on vient surmouler sur les éléments d'absorption de déformation 5a, 5b, 5c et 5d le matériau robuste constituant les coques de protection 4a, 4b, 4c et 4s, par exemple réalisé en PMMA.

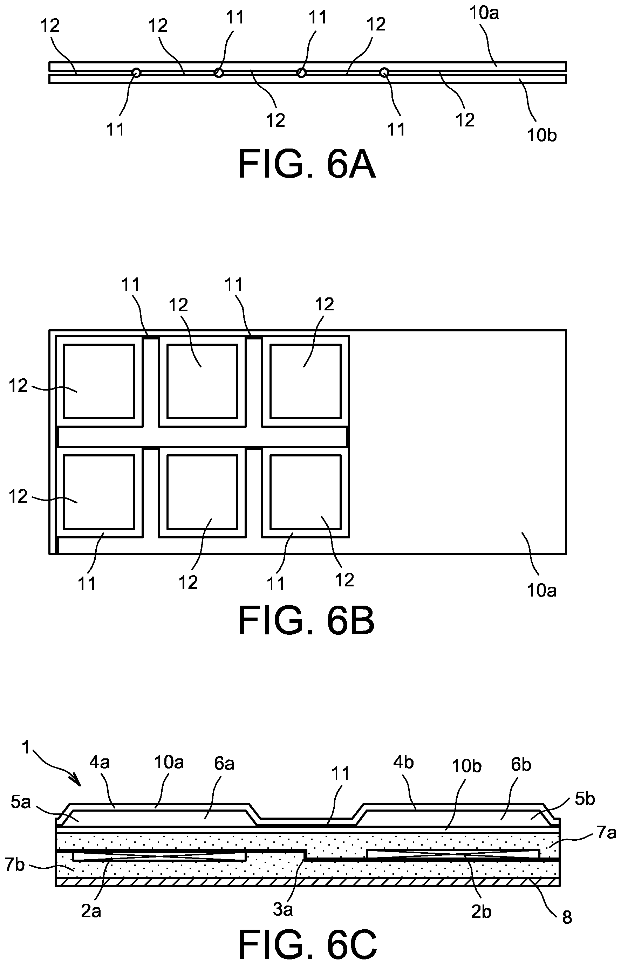

On a par ailleurs illustré sur les figures 6A à 6C un autre exemple de réalisation d'un procédé non conforme à l'invention. Dans cette variante, on utilise un procédé de soufflage pour former les coques de protection 4a, 4b, 4c et 4d et les éléments d'absorption de déformation 5a, 5b, 5c et 5d.

Ainsi, comme illustré sur la figure 6A, en coupe, la première étape consiste à thermosouder entre elles deux couches de matériau de protection 10a et 10b, par exemple formées par des films en PMMA, afin de former des carrés (visibles sur la figure 6B).

En particulier, les deux couches de matériau de protection 10a et 10b sont partiellement thermosoudées entre elles de sorte à former des zones assemblées par thermosoudage 11 et des zones 12 superposées mais non assemblées entre elles.

Ainsi, comme illustré en vue de face sur la figure 6B, on obtient un ensemble de zones non assemblées 12 sous la forme de carrés, sur lequel on prévoit par ailleurs une ouverture pour donner la possibilité d'injection d'un gaz, par exemple de l'air ou de l'azote, au cours de la troisième étape décrite en référence à la figure 6C.

Au cours de cette troisième étape, illustrée sur la figure 6C en coupe, on lamine les deux couches de matériau de protection 10a et 10b telles qu'obtenues au cours de l'étape illustrée en référence à la figure 6B, sur un ensemble du module photovoltaïque 1 tel qu'obtenu par exemple en référence à la figure 3A.

Puis, on injecte dans le module photovoltaïque 1, au niveau de l'ouverture 13 telle que représentée sur la figure 6B, un gaz sous haute pression, par exemple à une pression comprise entre 5 et 15 bars, de sorte à ce qu'il pénètre à l'intérieur des zones non assemblées 12 pour former les éléments d'absorption de déformation 5a et 5b, ainsi que les coques de protection 4a et 4b.

On a par ailleurs illustré, en perspective sur la figure 7A et en coupe sur la figure 7B, un autre exemple de réalisation d'un module photovoltaïque 1 conforme à l'invention.

Dans cet exemple, le module photovoltaïque 1 est dépourvu d'une couche de fond 8 et de couches de matériau d'encapsulation 7a et 7b telles que décrites précédemment.

En réalité, chacune des quatre cellules photovoltaïques 2a, 2b, 2c et 2d est recouverte de part et d'autre par un premier élément de protection 4a, 4b, 4c et 4d et un deuxième élément de protection 4e, 4f, 4g et 4h. En particulier, comme représenté sur la figure 7B, les premiers éléments de protection 4a, 4b, 4c et 4d viennent se superposer aux deuxièmes éléments de protection 4e, 4f, 4g et 4h, de sorte que chacune des cellules photovoltaïques 2a, 2b, 2c et 2d est enveloppée par ces premier et deuxième éléments de protection.

De cette façon, les cellules photovoltaïques 2a, 2b, 2c et 2d ne reposent plus sur un substrat souple tel que formé par encapsulation par utilisation de couches de matériau d'encapsulation 7a et 7b, comme décrit précédemment. Au contraire, elles sont prises en sandwich entre deux coques de protection.

Ce mode de réalisation peut permettre un assemblage simplifié des cellules photovoltaïques entre elles. En particulier, il peut ne plus être nécessaire d'encapsuler les cellules photovoltaïques entre elles.

De même, il peut ne plus être nécessaire d'assembler, notamment par soudure, les éléments de contact électrique sur toute la largeur des cellules photovoltaïques. En effet, une soudure est habituellement réalisée sur toute la largeur des cellules photovoltaïques pour l'assemblage des éléments de contact électrique afin d'éviter d'être gêné par la résine constituant les couches de matériau d'encapsulation 7a et 7b. Toutefois, sans utilisation de telles couches de matériau d'encapsulation 7a et 7b, une soudure partielle peut être suffisante.

Avantageusement, ce mode de réalisation des figures 7a et 7b peut permettre de protéger les cellules photovoltaïques 2a, 2b, 2c et 2d des contraintes extérieures au niveau de chacune de leurs faces opposées. Cette réalisation peut permettre d'obtenir une configuration bifaciale du module photovoltaïque 1.

Par ailleurs, la figure 8 illustre, en coupe et de manière simplifiée, la possibilité d'avoir un élément de contact électrique 3a qui soit au moins partiellement flexible, et notamment dans sa partie située entre deux cellules photovoltaïques 2a et 2b.

Plus précisément, dans certaines configurations d'utilisation du module photovoltaïque 1, les éléments de contact électrique peuvent être mécaniquement sollicités et peuvent en conséquence fragiliser les cellules photovoltaïques. Dans ce cas, il peut être nécessaire de prévoir des éléments de contact électrique suffisamment souples.

Pour ce faire, une première possibilité peut consister à jouer sur le rapport entre l'épaisseur et la largeur de chaque élément de contact électrique.

Une deuxième possibilité peut consister à remplacer la bande de cuivre habituelle formant l'élément de contact électrique par de la tresse à dessouder, telle qu'enseignée par exemple par la demande internationale WO 2012/028537 A1.

Enfin, une troisième possibilité, illustrée en référence à la figure 8, peut consister à utiliser au moins une portion 14b flexible dans la zone de l'élément de contact électrique 3A située entre les cellules photovoltaïques 2a et 2b.

Ainsi, l'élément de contact électrique 3a peut par exemple comporter deux portions 14a et 14c rigides respectivement assemblées aux deux cellules photovoltaïques 2a et 2b, par exemple par soudure ou collage, et comporter une portion centrale flexible 14b faisant la liaison entre les deux portions rigides 14a et 14c.

Bien entendu, l'invention n'est pas limitée aux exemples de réalisation qui viennent d'être décrits. Diverses modifications peuvent y être apportées par l'homme du métier.

L'expression « comportant un » doit être comprise comme étant synonyme de « comportant au moins un », sauf si le contraire est spécifié.

## Revendications

1. Dispositif électrique et/ou électronique (1) consistant en un module photovoltaïque, ledit dispositif comportant :
- au moins deux composants électriques et/ou électroniques (2a, 2b, 2c, 2d), chacun desdits au moins deux composants électriques et/ou électroniques (2a, 2b, 2c, 2d) comportant deux faces (2a₁, 2a₂ ; 2b₁, 2b₂ ; 2c₁, 2c₂ ; 2d₁, 2d₂) opposées, lesdits au moins deux composants électriques et/ou électroniques (2a, 2b, 2c, 2d) étant des cellules photovoltaïques,
- au moins un élément de contact électrique (3a, 3b, 3c, 3d) disposé contre au moins une des deux faces opposées (2a₁, 2a₂ ; 2b₁, 2b₂ ; 2c₁, 2c₂ ; 2d₁, 2d₂) de chacun desdits au moins deux composants électriques et/ou électroniques (2a, 2b, 2c, 2d) pour les relier électriquement entre eux,
chaque composant électrique et/ou électronique (2a, 2b, 2c, 2d) étant protégé mécaniquement par deux éléments de protection (4a, 4b, 4c, 4d, 4e, 4f, 4g, 4h) qui lui sont spécifiques, étant pris entre les deux éléments de protection (4a, 4b, 4c, 4d, 4e, 4f, 4g, 4h), un premier élément de protection (4a, 4b, 4c, 4d) étant disposé en superposition par rapport au composant électrique et/ou électronique (2a, 2b, 2c, 2d) qu'il protège, en regard de l'une de ses deux faces opposées (2a₁, 2a₂ ; 2b₁, 2b₂ ; 2c₁, 2c₂ ; 2d₁, 2d₂), et un deuxième élément de protection (4e, 4f, 4g, 4h) étant disposé en superposition par rapport au composant électrique et/ou électronique (2a, 2b, 2c, 2d) qu'il protège, en regard de l'autre de ses deux faces opposées (2a₁, 2a₂ ; 2b₁, 2b₂ ; 2c₁, 2c₂ ; 2d₁, 2d₂), **caractérisé en ce qu'**au moins un élément d'absorption de déformation (5a, 5b, 5c, 5d, 5e, 5f, 5g, 5h) est disposé dans au moins un espace (6a, 6b, 6c, 6d, 6e, 6f, 6g, 6h) formé entre au moins un élément de protection (4a, 4b, 4c, 4d, 4e, 4f, 4g, 4h) et le composant électrique et/ou électronique (2a, 2b, 2c, 2d) qu'il protège, ledit au moins un élément d'absorption de déformation (5a, 5b, 5c, 5d, 5e, 5f, 5g, 5h) comportant un gaz sous haute pression avec une pression comprise entre 5 et 15 bars.

2. Dispositif selon la revendication 1, **caractérisé en ce que** le premier élément de protection (4a, 4b, 4c, 4d) et le deuxième élément de protection (4e, 4f, 4g, 4h) sont assemblés entre eux, notamment par collage.

3. Dispositif selon la revendication 1 ou 2, **caractérisé en ce que** le premier élément de protection (4a, 4b, 4c, 4d) et le deuxième élément de protection (4e, 4f, 4g, 4h) forment respectivement, au moins en partie, des faces avant et arrière du dispositif électrique et/ou électronique (1), entre lesquels ne sont disposés que le composant électrique et/ou électronique (2a, 2b, 2c, 2d), que les premier et deuxième éléments de protection protègent, ledit au moins un élément de contact électrique (3a, 3b, 3c, 3d) qui lui est associé et au moins un premier élément d'absorption de déformation (5a, 5b, 5c, 5d) et un deuxième élément d'absorption (5e, 5f, 5g, 5h) disposés de part et d'autre dudit composant électrique et/ou électronique (2a, 2b, 2c, 2d).

4. Dispositif selon l'une quelconque des revendications précédentes, **caractérisé en ce qu'**il comporte une pluralité d'éléments de protection (4a, 4b, 4c, 4d, 4e, 4f, 4g, 4h) et **en ce qu'**au moins une partie des éléments de protection (4a, 4b, 4c, 4d, 4e, 4f, 4g, 4h) du dispositif électrique et/ou électronique (1), notamment la totalité, forme une disposition sensiblement régulière de formes polygonales, notamment rectangulaires ou carrés.

5. Dispositif selon l'une quelconque des revendications précédentes, **caractérisé en ce que** ledit au moins un élément de protection (4a, 4b, 4c, 4d, 4e, 4f, 4g, 4h) comporte au moins un canal ajouré (9a, 9b) permettant le passage dudit au moins un élément de contact électrique (3a, 3b, 3c, 3d).

6. Dispositif selon l'une quelconque des revendications précédentes, **caractérisé en ce que** ledit au moins un élément de protection (4a, 4b, 4c, 4d, 4e, 4f, 4g, 4h) est réalisé dans un matériau ayant une dureté supérieure à 60 sur l'échelle M rockwell, selon la norme « Standard Test Method for Rockwell Hardness of Plastics and Electrical Insulating Materials » ASTM D785.

7. Dispositif selon l'une quelconque des revendications précédentes, **caractérisé en ce que** ledit au moins un élément de protection (4a, 4b, 4c, 4d, 4e, 4f, 4g, 4h) est réalisé dans un matériau choisi parmi : du polyméthacrylate de méthyle (PMMA), du polycarbonate ou du verre.

8. Procédé de réalisation d'un dispositif électrique et/ou électronique (1), ledit dispositif étant un module photovoltaïque, le procédé comportant au moins les étapes de :
a) réalisation d'une pluralité de composants électriques et/ou électroniques (2a, 2b, 2c, 2d) comportant chacun deux faces (2a₁, 2a₂ ; 2b₁, 2b₂ ; 2c₁, 2c₂ ; 2d₁, 2d₂) opposées, lesdits composants électriques et/ou électroniques (2a, 2b, 2c, 2d) étant des cellules photovoltaïques,
b) réalisation de premiers éléments de protection (4a, 4b, 4c, 4d) et de deuxièmes éléments de protection (4e, 4f, 4g, 4h) destinés à protéger mécaniquement chacun desdits au moins deux composants électriques et/ou électroniques (2a, 2b, 2c, 2d),
le procédé comportant au moins les étapes successives suivantes :
- assemblage de ladite pluralité de composants (2a, 2b, 2c, 2d) entre eux par l'intermédiaire d'une pluralité d'éléments de contact électrique (3a, 3b, 3c, 3d) disposés contre au moins une des deux faces opposées (2a₁, 2a₂ ; 2b₁, 2b₂ ; 2c₁, 2c₂ ; 2d₁, 2d₂) de chacun de ladite pluralité de composants électriques et/ou électroniques (2a, 2b, 2c, 2d) pour les relier électriquement entre eux,
- assemblage de part et d'autre des composants électriques et/ou électroniques (2a, 2b, 2c, 2d) des premiers éléments de protection (4a, 4b, 4c, 4d) et des deuxièmes éléments de protection (4e, 4f, 4g, 4h) de sorte que les premiers éléments de protection (4a, 4b, 4c, 4d), les composants électriques et/ou électroniques (2a, 2b, 2c, 2d) et les deuxièmes éléments de protection (4e, 4f, 4g, 4h) soient superposées entre eux, les premiers éléments de protection (4a, 4b, 4c, 4d) étant assemblés aux deuxièmes éléments de protection (4e, 4f, 4g, 4h), chaque premier élément de protection (4a, 4b, 4c, 4d) et chaque deuxième élément de protection (4e, 4f, 4g, 4h) étant superposés au composant électrique et/ou électronique (2a, 2b, 2c, 2d) qu'ils protègent de sorte qu'une des deux faces opposées du composant électrique et/ou électronique (2a, 2b, 2c, 2d) soit disposée en regard du premier élément de protection (4a, 4b, 4c, 4d) et que l'autre des deux faces opposées du composant électrique et/ou électronique (2a, 2b, 2c, 2d) soit disposée en regard du deuxième élément de protection (4e, 4f, 4g, 4h),
le procédé étant **caractérisé en ce qu'**il comporte la réalisation d'au moins un élément d'absorption de déformation (5a, 5b, 5c, 5d, 5e, 5f, 5g, 5h), disposé dans au moins un espace (6a, 6b, 6c, 6d, 6e, 6f, 6g, 6h) formé entre l'un au moins du premier élément de protection (4a, 4b, 4c, 4d) et du deuxième élément de protection (4e, 4f, 4g, 4h) et le composant électrique et/ou électronique qu'ils protègent,
ledit au moins un élément d'absorption de déformation (5a, 5b, 5c, 5d, 5e, 5f, 5g, 5h) comportant un gaz sous haute pression avec une pression comprise entre 5 et 15 bars.

## Patentansprüche

1. Elektrische und/oder elektronische Vorrichtung (1), bestehend aus einem photovoltaischen Modul, wobei die Vorrichtung Folgendes umfasst:
- wenigstens zwei elektrische und/oder elektronische Komponenten (2a, 2b, 2c, 2d), wobei jede der wenigstens zwei elektrischen und/oder elektronischen Komponenten (2a, 2b, 2c, 2d) zwei entgegengesetzte Flächen (2a₁, 2a₂; 2b₁, 2b₂; 2c₁, 2c₂; 2d₁, 2d₂) umfasst, wobei die wenigstens zwei elektrischen und/oder elektronischen Komponenten (2a, 2b, 2c, 2d) photovoltaische Zellen sind,
- wenigstens ein elektrisches Kontaktelement (3a, 3b, 3c, 3d), das gegen wenigstens eine der zwei entgegengesetzten Flächen (2a₁, 2a₂; 2b₁, 2b₂; 2c₁, 2c₂; 2d₁, 2d₂) von jeder der wenigstens zwei elektrischen und/oder elektronischen Komponenten (2a, 2b, 2c, 2d) angeordnet ist, um sie elektrisch miteinander zu verbinden,
wobei jede elektrische und/oder elektronische Komponente (2a, 2b, 2c, 2d) mechanisch geschützt ist durch zwei für sie spezifische Schutzelemente (4a, 4b, 4c, 4d, 4e, 4f, 4g, 4h), und zwischen die zwei Schutzelemente (4a, 4b, 4c, 4d, 4e, 4f, 4g, 4h) gesetzt ist, wobei ein erstes Schutzelement (4a, 4b, 4c, 4d) in Überlagerung mit Bezug zu der elektrischen und/oder elektronischen Komponente (2a, 2b, 2c, 2d) angeordnet ist, die es schützt, gegenüber von der einen ihrer zwei entgegengesetzten Flächen (2a₁, 2a₂; 2b₁, 2b₂; 2c₁, 2c₂; 2d₁, 2d₂), und ein zweites Schutzelement (4e, 4f, 4g, 4h) in Überlagerung mit Bezug zu der elektrischen und/oder elektronischen Komponente (2a, 2b, 2c, 2d) angeordnet ist, die es schützt, gegenüber der anderen ihrer zwei entgegengesetzten Flächen (2a₁, 2a₂; 2b₁, 2b₂; 2c₁, 2c₂; 2d₁, 2d₂),
**dadurch gekennzeichnet, dass** wenigstens ein Verformungsabsorptionselement (5a, 5b, 5c, 5d, 5e, 5f, 5g, 5h) in wenigstens einem Raum (6a, 6b, 6c, 6d, 6e, 6f, 6g, 6h) angeordnet ist, der gebildet ist zwischen wenigstens einem Schutzelement (4a, 4b, 4c, 4d, 4e, 4f, 4g, 4h) und der elektrischen und/oder elektronischen Komponente (2a, 2b, 2c, 2d), die es schützt, wobei das wenigstens eine Verformungsabsorptionselement (5a, 5b, 5c, 5d, 5e, 5f, 5g, 5h) ein Gas unter hohem Druck mit einem Druck umfasst, der zwischen 5 und 15 bar enthalten ist.

2. Vorrichtung nach Anspruch 1, **dadurch gekennzeichnet, dass** das erste Schutzelement (4a, 4b, 4c, 4d) und das zweite Schutzelement (4e, 4f, 4g, 4h) miteinander verbunden sind, insbesondere durch Kleben.

3. Vorrichtung nach Anspruch 1 oder 2, **dadurch gekennzeichnet, dass** das erste Schutzelement (4a, 4b, 4c, 4d) und das zweite Schutzelement (4e, 4f, 4g, 4h) wenigstens teilweise vordere beziehungsweise hintere Flächen der elektrischen und/oder elektronischen Vorrichtung (1) bilden, zwischen denen nur die elektrische und/oder elektronische Vorrichtung (2a, 2b, 2c, 2d) angeordnet ist, die das erste und das zweite Schutzelement schützen, das wenigstens eine elektrische Kontaktelement (3a, 3b, 3c, 3d), das ihr zugeordnet ist, sowie wenigstens ein erstes Verformungsabsorptionselement (5a, 5b, 5c, 5d) und ein zweites Absorptionselement (5e, 5f, 5g, 5h), angeordnet auf beiden Seiten der elektrischen und/oder elektronischen Vorrichtung (2a, 2b, 2c, 2d).

4. Vorrichtung nach einem der vorhergehenden Ansprüche, **dadurch gekennzeichnet, dass** sie eine Mehrzahl von Schutzelementen (4a, 4b, 4c, 4d, 4e, 4f, 4g, 4h) umfasst, und dass wenigstens ein Teil der Schutzelemente (4a, 4b, 4c, 4d, 4e, 4f, 4g, 4h) der elektrischen und/oder elektronischen Vorrichtung (1), insbesondere alle, eine im Wesentlichen regelmäßige Anordnung mit polygonalen, insbesondere rechteckigen oder quadratischen Formen bildet.

5. Vorrichtung nach einem der vorhergehenden Ansprüche, **dadurch gekennzeichnet, dass** das wenigstens eine Schutzelement (4a, 4b, 4c, 4d, 4e, 4f, 4g, 4h) wenigstens einen durchbrochenen Kanal (9a, 9b) umfasst, der den Durchgang des wenigstens einen elektrischen Kontaktelements (3a, 3b, 3c, 3d) erlaubt.

6. Vorrichtung nach einem der vorhergehenden Ansprüche, **dadurch gekennzeichnet, dass** das wenigstens eine Schutzelement (4a, 4b, 4c, 4d, 4e, 4f, 4g, 4h) aus einem Material hergestellt ist, das eine Härte größer als 60 auf der M-Rockwellskala gemäß der Norm "Standard Test Method for Rockwell Hardness of Plastics and Electrical Insulating Materials" ASTM D785 hat.

7. Vorrichtung nach einem der vorhergehenden Ansprüche, **dadurch gekennzeichnet, dass** das wenigstens eine Schutzelement (4a, 4b, 4c, 4d, 4e, 4f, 4g, 4h) aus einem Material hergestellt ist, das ausgewählt ist aus: Polymethylmethacrylat (PMMA), Polycarbonat oder Glas.

8. Verfahren zur Herstellung einer elektrischen und/oder elektronischen Vorrichtung (1), wobei die Vorrichtung ein photovoltaisches Modul ist, wobei das Verfahren wenigstens die folgenden Schritte umfasst:
a) Herstellen einer Mehrzahl von elektrischen und/oder elektronischen Komponenten (2a, 2b, 2c, 2d), die jeweils zwei entgegengesetzte Flächen (2a₁, 2a₂; 2b₁, 2b₂; 2c₁, 2c₂; 2d₁, 2d₂) umfassen, wobei die elektrischen und/oder elektronischen Komponenten (2a, 2b, 2c, 2d) photovoltaische Zellen sind,
b) Herstellen von ersten Schutzelementen (4a, 4b, 4c, 4d) und von zweiten Schutzelementen (4e, 4f, 4g, 4h), die dazu ausgelegt sind, mechanisch jede von den wenigstens zwei elektrischen und/oder elektronischen Komponenten (2a, 2b, 2c, 2d) zu schützen,
wobei das Verfahren die folgenden aufeinanderfolgenden Schritte umfasst:
- Zusammenfügen der Mehrzahl von Komponenten (2a, 2b, 2c, 2d) miteinander mittels einer Mehrzahl von elektrischen Kontaktelementen (3a, 3b, 3c, 3d), die gegen wenigstens eine der zwei entgegengesetzten Flächen (2a₁, 2a₂; 2b₁, 2b₂; 2c₁, 2c₂; 2d₁, 2d₂) von jeder von der Mehrzahl von elektrischen und/oder elektronischen Komponenten (2a, 2b, 2c, 2d) angeordnet sind, um sie elektrisch miteinander zu verbinden,
- Zusammenfügen, auf beiden Seiten der elektrischen und/oder elektronischen Komponenten (2a, 2b, 2c, 2d), der ersten Schutzelemente (4a, 4b, 4c, 4d) und der zweiten Schutzelemente (4e, 4f, 4g, 4h) derart, dass die ersten Schutzelemente (4a, 4b, 4c, 4d), die elektrischen und/oder elektronischen Komponenten (2a, 2b, 2c, 2d) und die zweiten Schutzelemente (4e, 4f, 4g, 4h) einander überlagert sind, wobei die ersten Schutzelemente (4a, 4b, 4c, 4d) mit den zweiten Schutzelementen (4e, 4f, 4g, 4h) zusammengefügt sind, wobei jedes erste Schutzelement (4a, 4b, 4c, 4d) und jedes zweite Schutzelement (4e, 4f, 4g, 4h) mit der elektrischen und/oder elektronischen Komponente (2a, 2b, 2c, 2d), die sie schützen, derart überlagert sind, dass eine der zwei entgegengesetzten Flächen der elektrischen und/oder elektronischen Komponente (2a, 2b, 2c, 2d) gegenüber dem ersten Schutzelement (4a, 4b, 4c, 4d) angeordnet ist, und dass die andere der zwei entgegengesetzten Flächen der elektrischen und/oder elektronischen Komponente (2a, 2b, 2c, 2d) gegenüber dem zweiten Schutzelement (4e, 4f, 4g, 4h) angeordnet ist,
wobei das Verfahren **dadurch gekennzeichnet ist, dass** es die Herstellung wenigstens eines Verformungs absorptions elements (5a, 5b, 5c, 5d, 5e, 5f, 5g, 5h) umfasst, angeordnet in wenigstens einem Raum (6a, 6b, 6c, 6d, 6e, 6f, 6g, 6h), der gebildet ist zwischen wenigstens einem ersten Schutzelement (4a, 4b, 4c, 4d) und zweiten Schutzelement (4e, 4f, 4g, 4h) und der elektrischen und/oder elektronischen Komponente, die sie schützen,
wobei das wenigstens eine Verformungsabsorptionselement (5a, 5b, 5c, 5d, 5e, 5f, 5g, 5h) ein Gas unter hohem Druck mit einem Druck umfasst, der zwischen 5 und 15 bar enthalten ist.

## Claims

1. Electrical and/or electronic device (1) consisting in a photovoltaic module, said device comprising:
- at least two electrical and/or electronic components (2a, 2b, 2c, 2d), each of said at least two electrical and/or electronic components (2a, 2b, 2c, 2d) comprising two opposite faces (2a₁, 2a₂ ; 2b₁, 2b₂; 2c₁, 2c₂; 2d₁, 2d₂), said at least two electrical and / or electronic components (2a; 2b, 2c, 2d) being photovoltaic cells,
- at least one electrical contact element (3a, 3b, 3c, 3d) arranged against at least one of the two opposite faces (2a₁, 2a₂ ; 2b₁, 2b₂ ; 2c₁, 2c₂ ; 2d₁, 2d₂) of each of said at least two electrical and/or electronic components (2a, 2b, 2c, 2d), to electrically connect them, each electrical and/or electronic component (2a, 2b, 2c, 2d) being mechanically protected by two protective elements (4a, 4b, 4c, 4d, 4e, 4f, 4g, 4h) which are specific thereto, being taken between the two protective elements (4a, 4b, 4c, 4d, 4e, 4f, 4g, 4h), a first protective element (4a, 4b, 4c, 4d) being arranged in superposition with respect to the electrical and/or electronic component (2a, 2b, 2c, 2d) that it protects, facing one of its two opposite faces (2a₁, 2a₂ ; 2b₁, 2b₂; 2c₁, 2c₂ ; 2d₁, 2d₂), and a second protective element (4e, 4f, 4g, 4h) being arranged in superposition with respect to the electrical and/or electronic component (2a, 2b, 2c, 2d) that it protects, facing the other of its two opposite faces (2a₁, 2a₂ ; 2b₁, 2b₂ ; 2c₁, 2c₂ ; 2d₁, 2d₂),
**characterised in that** at least one deformation absorption element (5a, 5b, 5c, 5d, 5e, 5f, 5g, 5h) is arranged in at least one space (6a, 6b, 6c, 6d, 6e, 6f, 6g, 6h) formed between at least one protective element (4a, 4b, 4c, 4d, 4e, 4f, 4g, 4h) and the electrical and/or electronic component (2a, 2b, 2c, 2d) that it protects,
said at least one deformation absorption element (5a, 5b, 5c, 5d, 5e, 5f, 5g, 5h) comprises a gas under high pressure with a pressure of between 5 and 15 bar.

2. Device according to claim 1, **characterised in that** the first protective element (4a, 4b, 4c, 4d) and the second protective element (4e, 4f, 4g, 4h) are assembled together, notably by bonding.

3. Device according to claim 1 or 2, **characterised in that** the first protective element (4a, 4b, 4c, 4d) and the second protective element (4e, 4f, 4g, 4h) form respectively, at least in part, front and rear faces of the electrical and/or electronic device (1), between which are only arranged the electrical and/or electronic component (2a, 2b, 2c, 2d), that the first and second protective elements protect, said at least one electrical contact element (3a, 3b, 3c, 3d) that is associated with it and at least one first deformation absorption element (5a, 5b, 5c, 5d) and a second absorption element (5e, 5f, 5g, 5h) arranged on either side of said electrical and/or electronic component (2a, 2b, 2c, 2d).

4. Device according to any of the preceding claims, **characterised in that** it comprises a plurality of protective elements (4a, 4b, 4c, 4d, 4e, 4f, 4g, 4h) and **in that** at least one part of the protective elements (4a, 4b, 4c, 4d, 4e, 4f, 4g, 4h) of the electrical and/or electronic device (1), notably the totality, forms a substantially regular arrangement of polygonal, notably rectangular or square shapes.

5. Device according to any of the preceding claims, **characterised in that** said at least one protective element (4a, 4b, 4c, 4d, 4e, 4f, 4g, 4h) comprises at least one openwork channel (9a, 9b) enabling the passage of said at least one electrical contact element (3a, 3b, 3c, 3d).

6. Device according to any of the preceding claims, **characterised in that** said at least one protective element (4a, 4b, 4c, 4d, 4e, 4f, 4g, 4h) is made of a material having a hardness greater than 60 on the Rockwell M scale, according to the "Standard Test Method for Rockwell Hardness of Plastics and Electrical Insulating Materials" ASTM D785.

7. Device according to any of the preceding claims, **characterised in that** said at least one protective element (4a, 4b, 4c, 4d, 4e, 4f, 4g, 4h) is made from a material selected from: polymethyl methacrylate (PMMA), polycarbonate or glass.

8. Method for producing an electrical and/or electronic device (1), said device being a photovoltaic module, said method comprising at least the steps of:
a) producing a plurality of electrical and/or electronic components (2a, 2b, 2c, 2d) each comprising two opposite faces (2a₁, 2a₂ ; 2b₁, 2b₂; 2c₁, 2c₂; 2d₁, 2d₂), said electrical and / or electronic components (2a, 2b, 2c, 2d) being photovoltaic cells,
b) producing first protective elements (4a, 4b, 4c, 4d) and second protective elements (4e, 4f, 4g, 4h) intended for mechanically protecting each of said at least two electrical and/or electronic components (2a, 2b, 2c, 2d),
said method comprising at least the steps of:
- assembling said plurality of components (2a, 2b, 2c, 2d) together through the intermediary of a plurality of electrical contact elements (3a, 3b, 3c, 3d), arranged against at least one of the two opposite faces (2a₁, 2a₂ ; 2b₁, 2b₂ ; 2c₁, 2c₂ ; 2d₁, 2d₂) of each of said plurality of electrical and / or electronic components (2a, 2b, 2c, 2d) to electrically connect them,
- assembling on either side of the electrical and/or electronic components (2a, 2b, 2c, 2d) said first protective elements (4a, 4b, 4c, 4d) and said second protective elements (4e, 4f, 4g, 4h), such that the first protective elements (4a, 4b, 4c, 4d), the electrical and/or electronic components (2a, 2b, 2c, 2d) and the second protective elements (4e, 4f, 4g, 4h) are superimposed together, the first protective elements (4a, 4b, 4c, 4d) being assembled on the second protective elements (4e, 4f, 4g, 4h), each first protective element (4a, 4b, 4c, 4d) and each second protective element (4e, 4f, 4g, 4h) being superimposed to the electrical and / or electronic component (2a, 2b, 2c, 2d) they protect such that one of the two opposite faces of said electrical and / or electronic component (2a, 2b, 2c, 2d) is disposed facing the first protective element (4a, 4b, 4c, 4d) and the other of the two opposite faces of said electrical and / or electronic component (2a, 2b, 2c, 2d) is disposed facing the second protective element (4e, 4f, 4g, 4h), said method being **characterised in that** it comprises the production of at least one deformation absorption element (5a, 5b, 5c, 5d, 5e, 5f, 5g, 5h), arranged in at least one space (6a, 6b, 6c, 6d, 6e, 6f, 6g, 6h) formed between at least one of the said first protective element (4a, 4b, 4c, 4d) and said second protective element (4e, 4f, 4g, 4h) and the electrical and / or electronic component they protect, said at least one deformation absorption element (5a, 5b, 5c, 5d, 5e, 5f, 5g, 5h) comprising a gas under high pressure with a pressure of between 5 and 15 bar.
